# EUROPÄISCHE PATENTSCHRIFT

(11) **EP 2 383 533 B1**
(45) Veröffentlichungstag und Bekanntmachung des Hinweises auf die Patenterteilung: **29.03.2023**
(21) Anmeldenummer: 11162355.9
(22) Anmeldetag: 14.04.2011
(51) Int. Cl.: F28D 7/16, F28F 1/02, F28F 1/40, F01N 5/02, F01N 3/04, F28D 7/00, B21D 53/02, H01L 35/28, H01L 35/32

(54) **Wärmeübertragungsanordnung, Wärmeübertrager und Herstellungsverfahren**
Heat transfer assembly, heat transfer device and production method
Agencement caloporteur, caloporteur et procédé de fabrication

(30) Priorität: 20.05.2010 DE 102010022225; 28.04.2010 DE 102010018478
(43) Veröffentlichungstag der Anmeldung: 02.11.2011
(73) Patentinhaber: Purem GmbH, 66539 Neunkirchen (DE)
(72) Erfinder: Oesterle, Jörg, 89150 Laichingen (DE); Bürkle, Anika, 70199 Stuttgart (DE); Sachse, Angela, 70771 Leinfelden-Echterdingen (DE); Dong, Ming, 7034 Stuttgart (DE); Spieth, Arnulf, 73269 Hochdorf (DE); Wirth, Georg, 73230 Kirchheim/Teck (DE)
(74) Vertreter: BRP Renaud & Partner mbB Rechtsanwälte Patentanwälte Steuerberater

(56) Entgegenhaltungen:
- EP-A1- 0 010 499
- EP-A2- 1 203 923
- WO-A1-2007/026432
- AT-A2- 506 262
- DE-A1-102008 023 937
- DE-T2- 60 200 731
- DE-T2- 69 720 909
- JP-A- 2005 351 567
- US-A1- 2006 157 102

## Beschreibung

Die vorliegende Erfindung betrifft eine Anordnung zur Wärmeübertragung zwischen einem zum Führen eines Fluids geeigneten Rohrkörper und einem damit in Kontakt stehenden Kontaktkörper. Die Erfindung betrifft außerdem einen Wärmeübertrager für eine Abgasanlage einer Brennkraftmaschine, insbesondere eines Kraftfahrzeugs, der mit einer derartigen Wärmeübertragungsanordnung ausgestattet ist. Außerdem betrifft die Erfindung ein Verfahren zum Herstellen einer derartigen Wärmeübertragungsanordnung.

In vielen Bereichen der Technik ist es erforderlich, zwischen einem Rohrkörper, der ein Fluid führt, und einem damit in Kontakt stehenden Kontaktkörper eine möglichst effektive Wärmeübertragung zu erzielen. Beispielsweise soll Wärme aus dem Fluid in den Kontaktkörper eingeleitet werden oder soll umgekehrt Wärme aus dem Kontaktkörper in das Fluid übertragen und abgeführt werden. Somit kommen derartige Wärmeübertragungsanordnungen zum Kühlen oder zum Heizen eines Kontaktkörpers mittels einer Fluidströmung zur Anwendung. Dabei ist es grundsätzlich möglich, dass es sich beim Kontaktkörper ebenfalls um ein Fluid führendes Rohr handelt, so dass über die Anordnung letztlich Wärme von dem einen Fluid in das andere Fluid übertragen werden kann.

Bei modernen Anwendungen kommen thermoelektrische Wandler bzw. thermoelektrische Generatoren zum Einsatz, die eine Temperaturdifferenz in eine Spannungsdifferenz wandeln bzw. einen Wärmestrom in einen elektrischen Strom wandeln. Derartige thermoelektrische Generatoren arbeiten nach dem umgekehrten Peltier-Effekt und funktionieren daher analog zu Peltier-Elementen. In einem Wärmeübertrager können nun derartige thermoelektrische Generatoren jeweils zwischen einem Warmrohr, das ein wärmeabgebendes Fluid führt, und einem Kaltrohr angeordnet sein, das ein wärmeaufnehmendes Fluid führt. Die Temperaturdifferenz zwischen Warmrohr und Kaltrohr liegt dann am jeweiligen thermoelektrischen Wandler an und kann in elektrischen Strom gewandelt werden.

Bei all diesen Anwendungen ist es zur Realisierung einer möglichst hohen Effizienz der Wärmeübertragung erforderlich, dass ein flächiger Kontakt zwischen dem jeweiligen Rohrkörper und dem jeweiligen Kontaktkörper vorliegt, und zwar über den gesamten Temperaturbereich, den die Anordnung während eines ordnungsgemäßen Betriebs durchläuft. Um die gewünschte flächige Kontaktierung zu gewährleisten und um den Wärmeübertrag zu verbessern, ist es grundsätzlich möglich, den Rohrkörper und den Kontaktkörper mit Hilfe einer Vorspannkraft aneinander anzudrücken. Es hat sich jedoch gezeigt, dass bei Rohrkörpern häufig eine Beulung eintritt, wenn die Vorspannkraft zu groß gewählt ist. Durch die Beulung kann der Rohrkörper bereichsweise vom Kontaktkörper abheben, so dass der vormals flächige Kontakt zum Kontaktkörper streifenförmig oder linienförmig wird, was die Wärmeübertragung erheblich beeinträchtigt. Hinzu kommen Wärmedehnungseffekte, bei denen sich der jeweilige Rohrkörper, der jeweilige Kontaktkörper sowie Vorspannmittel zum Erzeugen der Vorspannkraft unterschiedlich ausdehnen können, wodurch es zu einer Veränderung der Vorspannkraft kommen kann, so dass die Beulung des Rohrkörpers beispielsweise erst bei höheren Temperaturen auftritt.

Das Dokument AT506262 offenbart eine Wärmeübertragungsanordnung gemäß dem nächstkommenden Stand der Technik.

Die vorliegende Erfindung beschäftigt sich mit dem Problem, für eine Wärmeübertragungsanordnung bzw. für einen Wärmeübertrager bzw. für ein zugehöriges Herstellungsverfahren eine verbesserte Ausführungsform anzugeben, die sich insbesondere durch eine besonders effektive Wärmeübertragung auszeichnet.

Dieses Problem wird erfindungsgemäß durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, den jeweiligen Rohrkörper so herzustellen, dass er in einem unverspannten Zustand der Anordnung eine zum Kontaktkörper hin konvex gewölbte Außenseite aufweist, die sich im verspannten Zustand gegenüber dem unverspannten Zustand deformiert und dadurch flächig am Kontaktkörper zur Anlage kommt. Diese Bauweise wirkt einer Beulung des Rohrkörpers entgegen und führt zu einer hochwertigen, flächigen Kontaktierung zwischen Rohrkörper und Kontaktkörper. Damit diese hochwertige Kontaktierung auch bei variierenden Vorspannkräften beibehalten werden kann, schlägt die Erfindung außerdem vor, im Inneren des Rohrkörpers eine Stützstruktur anzuordnen, derart, dass sich die Stützstruktur im verspannten Zustand an zwei einander gegenüberliegenden Innenseiten des Rohrkörpers in der Verspannungsrichtung abstützt. Mit Hilfe dieser Stützstruktur kann ein Beulen des Rohrkörpers nach innen effektiv verhindert werden. In der Folge bleibt auch bei wechselnden Vorspannkräften die flächige Kontaktierung zwischen Rohrkörper und Kontaktkörper erhalten. Somit kann auch für wechselnde Temperaturen eine hochwertige, effektive Wärmeübertragung zwischen Rohrkörper und Kontaktkörper erreicht werden.

Gemäß einer vorteilhaften Ausführungsform kann eine Kontaktseite des Kontaktkörpers, an welcher die Außenseite des Rohrkörpers zur Anlage kommt, im unverspannten Zustand im Querschnitt des Kontaktkörpers eben sein. Dies ist dann von Vorteil, wenn der Kontaktkörper im Vergleich zum Rohrkörper eine deutlich höhere Steifigkeit besitzt. Dies ist beispielsweise dann der Fall, wenn es sich beim Kontaktkörper um einen thermoelektrischen Wandler handelt.

Gemäß einer anderen Ausführungsform kann vorgesehen sein, dass die Kontaktseite und die Außenseite im verspannten Zustand im Querschnitt der Körper in einer Ebene flächig aneinander liegen. Mit anderen Worten, die konvex gewölbte Außenseite wird im verspannten Zustand soweit deformiert, bis sie flächig an der ebenen Kontaktseite anliegt. Insgesamt baut die Anordnung dadurch vergleichsweise kompakt.

Die Stützstruktur kann aus einem wellenförmig oder zick-zack-förmig oder rechteckförmig gefalteten oder gewellten Bahnenmaterial gebildet sein. Hierdurch besitzt die Stützstruktur einen einfachen Aufbau, so dass sie preiswert realisierbar ist. Zweckmäßig erstreckt sich dabei eine Erstreckungsrichtung oder Längsrichtung der Wellen bzw. Falten parallel zur Längsrichtung des Rohrkörpers. Hierdurch bildet die Stützstruktur im Rohrkörper nur einen sehr geringen Strömungswiderstand.

Die Stützstruktur kann bei einer anderen Ausführungsform zumindest ein Rohr aufweisen. Ein derartiges Rohr kann einen runden, insbesondere kreisrunden oder elliptischen oder ovalen, oder auch einen eckigen, insbesondere quadratischen oder rechteckigen, Querschnitt aufweisen. Eine rohrförmige Stützstruktur besitzt eine besonders hohe Stabilität. Zweckmäßig verläuft eine Längsrichtung des Rohrs der Stützstruktur parallel zur Längsrichtung des Rohrkörpers.

Zur vereinfachten Herstellung ist die Stützstruktur nur an einer der beiden Innenseiten des Rohrkörpers befestigt.

Somit erfolgt die Positionierung der Stützstruktur innerhalb des Rohrkörpers nur an einer der beiden Innenseiten. Hierdurch kann der Rohrkörper im unverspannten Zustand seine gewölbte Außenseite besitzen, ohne dass hierzu auch die Stützstruktur verformt werden muss.

Wie bereits mehrfach erläutert, kann es sich beim Kontaktkörper zweckmäßig um einen thermoelektrischen Wandler bzw. um einen thermoelektrischen Generator handeln, der eine Temperaturdifferenz in elektrischen Strom wandelt.

Die Kontaktierung zwischen Kontaktkörper und Rohrkörper erfolgt direkt oder indirekt. Bei einer direkten Kontaktierung liegt der Rohrkörper mit seiner Außenseite unmittelbar an der Kontaktseite des Kontaktkörpers an. Bei einer indirekten Kontaktierung ist zwischen der Außenseite und der Kontaktseite ein weiteres Bauteil angeordnet, bei dem es sich zweckmäßig um eine Wärmeleitschicht handelt. Mit Hilfe einer derartigen Wärmeleitschicht kann die Wärmeübertragung zwischen Rohrkörper und Kontaktkörper verbessert werden. Insbesondere kann eine derartige Wärmeleitschicht geringfügige, toleranzbedingte Formabweichungen zwischen der Außenseite und der Kontaktseite ausgleichen. Anstelle einer separaten Wärmeleitschicht, die zwischen Kontaktseite und Außenseite angeordnet ist, kann bei einer anderen Ausführungsform auch vorgesehen sein, den Kontaktkörper an seiner Kontaktseite mit einer derartigen Wärmeleitschicht auszustatten, derart, dass die Wärmeleitschicht dann einen Bestandteil des Kontaktkörpers bzw. der Kontaktseite bildet. Zusätzlich oder alternativ kann auch der Rohrkörper bzw. dessen Außenseite mit einer derartigen Wärmeleitschicht versehen sein, derart, dass die jeweilige Wärmeleitschicht dann einen Bestandteil des Rohrkörpers bzw. der Außenseite bildet. In diesen Fällen liegt dann trotz Wärmeleitschicht eine direkte Kontaktierung zwischen Kontaktkörper und Rohrkörper vor.

Gemäß einer anderen Ausführungsform, kann die Stützstruktur eine strukturierte Oberfläche besitzen, derart, dass sich der Strömungswiderstand erhöht und die Wärmeübertragung verbessert ist. Insbesondere kann mit Hilfe einer gezielten Oberflächenstrukturierung die Entstehung turbulenter Grenzschichten an der Stützstruktur unterstützt werden. Die Stützstruktur besitzt dann die Zusatzfunktion eines Turbulators.

Die hier vorgestellte Wärmeübertragungsanordnung kann insbesondere in einem Wärmeübertrager für eine Abgasanlage einer Brennkraftmaschine, insbesondere eines Kraftfahrzeugs, realisiert werden. Ein derartiger Wärmeübertrager umfasst zumindest ein Warmrohr zum Führen eines wärmeabgebenden Fluids, zumindest ein Kaltrohr zum Führen eines wärmeaufnehmenden Fluids und zumindest einen thermoelektrischen Generator zum Wandeln einer Temperaturdifferenz in elektrische Spannung. Dabei ist der jeweilige thermoelektrische Generator jeweils zwischen einem Kaltohr und einem Warmrohr angeordnet und mit diesen verspannt. Diese Anordnung des jeweiligen thermoelektrischen Generators mit dem jeweiligen Rohr ist dabei als erfindungsgemäße Wärmeübertragungsanordnung ausgestaltet, wobei der Rohrkörper der Wärmeübertragungsanordnung durch das jeweilige Rohr, also durch ein Warmrohr oder durch ein Kaltrohr gebildet ist, während der Kontaktkörper der Wärmeübertragungsanordnung durch den jeweiligen thermoelektrischen Generator gebildet ist.

Die erfindungsgemäße Wärmeübertragungsanordnung kann beispielsweise so hergestellt werden, dass die Stützstruktur in den jeweiligen Rohrkörper eingebracht wird, dass anschließend der jeweilige Rohrkörper umgeformt wird, bis seine Außenseite nach außen konvex gewölbt ist, dass anschließend der jeweilige Kontaktkörper am Rohrkörper angeordnet wird und dass anschließend die Anordnung aus wenigstens einem Rohrkörper und wenigstens einem Kontaktkörper verspannt wird. Die Umformung des Rohrkörpers erst nach dem Einbringen der Stützstruktur stellt sicher, dass die Stützstruktur beim nachfolgenden Verspannen die Stützfunktion erfüllen kann, wenn der Rohrkörper durch die Verspannung erneut verformt wird. Zweckmäßig kann die Umformung des Rohrkörpers mittels Innenhochdruckumformung realisiert werden.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.

Es zeigen, jeweils schematisch
- Fig. 1: einen stark vereinfachten Querschnitt durch eine Wärmeübertragungsanordnung im verspannten Zustand,
- Fig. 2: einen stark vereinfachten Querschnitt durch einen Wärmeübertrager,
- Fig. 3: ein Querschnitt wie in Fig. 1, jedoch im unverspannten Zustand,
- Fig. 4-7: Querschnitte eines Rohrkörpers im verspannten Zustand bei verschiedenen anderen Ausführungsformen,
- Fig. 8: eine Wärmeübertragungsanordnung bei verschiedenen Zuständen a bis e ihrer Herstellung.

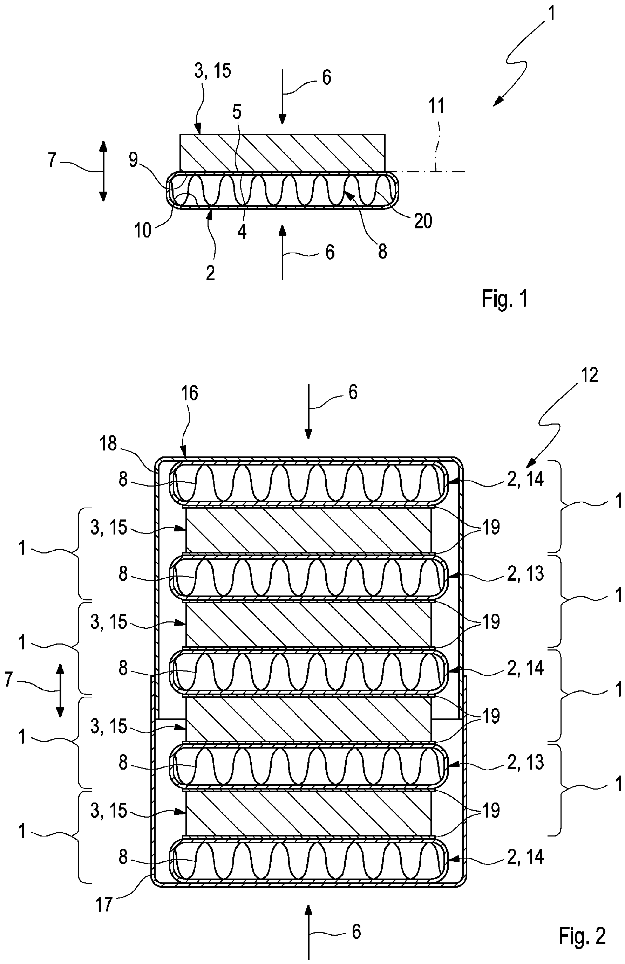

Entsprechend Fig. 1 umfasst eine Anordnung 1 zur Wärmeübertragung, die im Folgenden auch als Wärmeübertragungsanordnung 1 bezeichnet wird, einen Rohrkörper 2 und einen Kontaktkörper 3. Der Rohrkörper 2 dient zum Führen eines Fluids, bei dem es sich um eine Flüssigkeit oder um ein Gas handeln kann. Der Kontaktkörper 3 ist bevorzugt ein thermoelektrischer Wandler oder thermoelektrischer Generator 15. Grundsätzlich kann es sich hierbei jedoch auch um ein anderes Bauteil handeln, von dem Wärme abgeführt oder dem Wärme zugeführt werden muss. Die Anordnung 1 dient zur Wärmeübertragung zwischen dem Rohrkörper 2 und dem Kontaktkörper 3, der hierzu mit dem Rohrkörper 2 in Kontakt steht. Rohrkörper 2 und Kontaktkörper 3 sind separate Bauteile, die insbesondere lose aneinander anliegen, also nicht aneinander befestigt sind. Es ist jedoch auch eine Ausführungsform möglich, bei der Rohrkörper 2 und Kontaktkörper 3 aneinander befestigt sein können, z.B. durch Verklebung, Verlötung, Verschweißung.

Der Kontaktkörper 3 weist eine dem Rohrkörper 2 zugewandte Kontaktseite 4 auf. Der Rohrkörper 2 weist eine dem Kontaktkörper 3 zugewandte Außenseite 5 auf. Der Kontaktkörper 3 steht mit seiner Kontaktseite 4 mit der Außenseite 5 des Rohrkörpers 2 in Kontakt. In dem in Fig. 1 gezeigten verspannten Zustand der Anordnung 1 wirkt eine durch Pfeile angedeutete Vorspannkraft 6, die den Kontaktkörper 3 in einer durch einen Doppelpfeil angedeuteten Vorspannrichtung 7 gegen den Rohrkörper 2 andrückt. Hierdurch wird eine flächige Kontaktierung zwischen Kontaktseite 4 und Außenseite 5 realisiert.

Im Inneren des Rohrkörpers 2 ist eine Stützstruktur 8 angeordnet. Diese stützt sich im verspannten Zustand der Fig. 1 an zwei Innenseiten 9 und 10 des Rohrkörpers 2, die einander gegenüberliegen, in der Vorspannrichtung 7 ab. Hierdurch kann effektiv eine in das Innere des Rohrkörpers 2 orientierte Beulenbildung an der Außenseite 5 behindert bzw. verhindert werden.

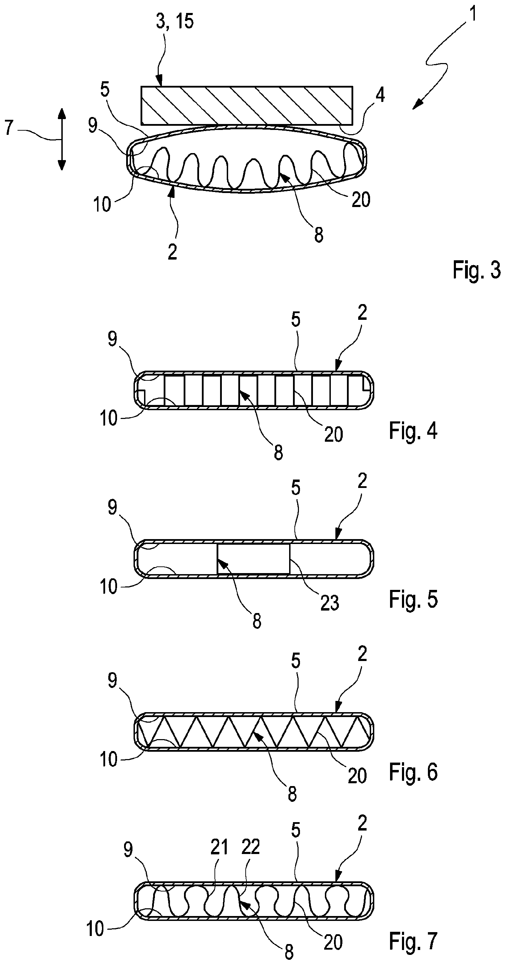

Fig. 3 zeigt die Anordnung 1 in einem unverspannten Zustand, bei dem die Vorspannkraft 6 nicht aufgebracht wird. In diesem unverspannten Zustand ist die Außenseite 5 zum Kontaktkörper 3 hin konvex gewölbt. In diesem unverspannten Zustand der Anordnung 1 kann im Wesentlichen nur eine linienförmige oder bestenfalls streifenförmige Kontaktierung zwischen Außenseite 5 und Kontaktseite 4 realisiert werden. Erkennbar ist dementsprechend die Außenseite 5 im verspannten Zustand gemäß Fig. 1 gegenüber dem unverspannten Zustand gemäß Fig. 3 deformiert, derart, dass sie im verspannten Zustand gemäß Fig. 1 flächig an der Kontaktseite 4 zur Anlage kommt.

Durch die Verspannung mit Hilfe der Vorspannkraft 6 wird somit der Rohrkörper 2 verformt, vorzugsweise elastisch. Im Unterschied dazu wird der Kontaktkörper 3 aufgrund der Vorspannkraft 6 nicht oder nur unwesentlich verformt. Bemerkenswert ist ferner, dass die Stützstruktur 8 im verspannten Zustand der Fig. 1 die beiden Innenseiten 9, 10 in der Vorspannrichtung 7 aneinander abstützt. Im Unterschied dazu liegt die Stützstruktur 8 im unverspannten Zustand der Fig. 3 nur an der einen Innenwand 10 mehr oder weniger an, während sie von der anderen Innenwand 9 beabstandet ist und dementsprechend ihre Stützfunktion nicht erfüllt.

Die Kontaktseite 4 des Kontaktkörpers 3 kann gemäß Fig. 3 auch im unverspannten Zustand im Querschnitt des Kontaktkörpers 3 eben sein. Bei hinreichender Steifigkeit des Kontaktkörpers 3 führt die ebene Kontaktseite 4 im verspannten Zustand der Fig. 1 dazu, dass die Kontaktseite 4 und die Außenseite 5 im Querschnitt der Körper 2, 3 in einer Ebene 11 flächig aneinander liegen. Dies kann zur Realisierung einer möglichst kompakten Bauform sowie einer einfachen Herstellbarkeit genutzt werden.

Gemäß Fig. 2 umfasst ein Wärmeübertrager 12, der bei einer Abgasanlage einer Brennkraftmaschine, insbesondere eines Kraftfahrzeugs, zur Anwendung kommen kann, zumindest ein Warmrohr 13, das zum Führen eines wärmeabgebenden Fluids dient, sowie zumindest ein Kaltrohr 14, das zum Führen eines wärmeaufnehmenden Fluids dient. Beispielsweise können die Warmrohre 13 Abgase führen, die in der Abgasanlage von der Brennkraftmaschine abgeführt werden. Im Unterschied dazu können die Kaltrohre 14 Kühlmittel eines Kühlkreises der Brennkraftmaschine führen, der beispielsweise zum Beheizen eines Fahrzeuginnenraums genutzt werden kann.

Ferner umfasst der hier gezeigte Wärmeübertrager 12 zumindest einen thermoelektrischen Generator 15, mit dessen Hilfe eine Temperaturdifferenz in eine elektrische Spannung gewandelt werden kann. Der jeweilige thermoelektrische Generator 15 ist jeweils zwischen einem Kaltrohr 14 und einem Warmrohr 13 angeordnet und mit diesem verspannt. Eine entsprechende Vorspannkraft ist wieder durch Pfeile 6 angedeutet, ebenso wie die zugehörige Vorspannrichtung 7 durch einen Doppelpfeil angedeutet ist.

In diesem Wärmeübertrager 12 bildet nun der jeweilige thermoelektrische Generator 15 mit dem jeweiligen Warmrohr 13 bzw. mit dem jeweiligen Kaltrohr 14 eine Wärmeübertragungsanordnung 1, die zuvor mit Bezug auf die Fig. 1 und 3 erläutert worden ist. Geschweifte Klammern kennzeichnen dabei in Fig. 2 die realisierten Wärmeübertragungsanordnungen 1. Innerhalb der jeweiligen Wärmeübertragungsanordnung 1 bildet der thermoelektrische Generator 15 jeweils den Kontaktkörper 3, während das jeweilige Rohr, also entweder das Warmrohr 13 oder das Kaltrohr 14, den zugehörigen Rohrkörper 2 der Anordnung 1 bildet. Dementsprechend ist im jeweiligen Rohr 13, 14 ebenfalls eine Stützstruktur 8 vorgesehen.

Im gezeigten Beispiel sind 3 Kaltrohre 14 und zwei Warmrohre 13 vorgesehen, so dass an entgegengesetzten Enden des Wäremübertragers 12, hier oben und unten, je ein Kaltrohr 14 vorhanden ist. Dies ist im Hinblick auf die Energieübertragung auf die elektrothermischen Generatoren 15 von Vorteil. Grundsätzlich kann jedes Warmrohr 13 und jedes Kaltrohr 14 einen verformten Rohrkörper 2 der Anordnung 1 bilden. Es ist jedoch auch eine Ausführungsform möglich, bei der nur die Kaltrohre 14 als verformter Rohrkörper 2 der Anordnung 1 ausgestaltet sind, während die Warmrohre 13 auch im verspannten Zustand im Wesentlichen unverformt sind. Alternativ ist es ebenso möglich, nur die Warmrohre 13 als verformte Rohrkörper 2 der Anordnung 1 auszugestalten, während die Kaltrohre 14 auch im verspannten Zustand im Wesentlichen unverformt sind.

Zur Realisierung der Verspannung bzw. zum Einleiten der Vorspannkraft 6 weist der Wärmeübertrager 12 ein Gehäuse 16 auf, das im Beispiel zwei im Profil U-förmig Gehäusehälften 17 und 18 besitzt, die in der Vorspannrichtung 7 ineinander gesteckt sind, so dass nun beispielsweise mittels eines Spannbands oder einer Schweißverbindung oder einer Schraubverbindung oder dergleichen die Vorspannkraft 6 in die Gehäusehälften 17, 18 und über diese auf die Anordnungen 1 aufgebracht werden kann. Es ist klar, dass hier grundsätzlich auch beliebige andere geeignete Profile bzw. Formen für die Gehäusehälften 17, 18 verwendet werden können, wie z.B. C-förmig, I-förmig, L-förmig und T-förmig, solange das jeweilige Gehäuse 16 die gewünschte interne Vorspannung bzw. Verspannung zum Erzeugen der Vorspannkraft 6 realisieren kann.

Die Anordnungen 1, die im Wärmeübertrager 12 der Fig. 2 verwendet werden, zeichnen sich außerdem dadurch aus, dass zwischen dem jeweiligen Rohr 13, 14 bzw. dem Rohrkörper 2 und dem jeweiligen thermoelektrischen Generator 15 bzw. dem Kontaktkörper 3 eine Wärmeleitschicht 19 angeordnet ist. Somit liegen Kontaktkörper 3 und Rohrkörper 2 in diesem Fall nicht direkt, sondern indirekt, nämlich über die jeweilige Wärmeleitschicht 19 aneinander an.

Generell kann bei allen Anordnungen 1 eine derartige Wärmeleitschicht 19 zwischen der Kontaktseite 4 und der Außenseite 5 angeordnet sein. In diesem Fall kann die Wärmeleitschicht 19 dann als separates Bauteil zwischen Kontaktkörper 3 und Rohrkörper 2 angeordnet werden. Ebenso ist es möglich, die Wärmeleitschicht 19 als Bestandteil des Rohrkörpers 2 an dessen Außenseite 5 anzubringen. Zusätzlich oder alternativ kann eine solche Wärmeleitschicht 19 als Bestandteil des Kontaktkörpers 3 an dessen Kontaktseite 4 angebracht sein. Soweit die Wärmeleitschicht 19 dann einen Bestandteil des Kontaktkörpers 3 oder der Kontaktseite 5 bildet bzw. einen Bestandteil des Rohrkörpers 2 oder der Außenseite 5 bildet, erfolgt die Kontaktierung zwischen Rohrkörper 2 und Kontaktkörper 3 wieder direkt.

Sofern die jeweilige Wärmeleitschicht 19 als separates Element oder Bauteil realisiert ist, kann sie z.B. aus einer Kohlenstofffolie oder aus einer Graphitfolie hergestellt sein oder bestehen, die z.B. auf einer Glimmerbasis beruht. Ebenso kann die jeweilige Wärmeleitschicht 19 auf einer Silikonbasis beruhen. Alternativ sind auch Wärmeleitschichten 19 aus Kaptonfolien oder Aramidgewebe denkbar. Geeignet zur Herstellung einer solchen Wärmeleitschicht 19 ist grundsätzlich jedes Material mit vergleichsweise hoher Wärmeleitfähigkeit. Bevorzugt soll das jeweilige Material der Wärmeleitschicht 19 eine vergleichsweise hohe Nachgiebigkeit besitzen, beispielsweise um Fertigungstoleranzen ausgleichen zu können, was den flächigen Kontakt und dementsprechend den Wärmeübergang verbessert.

Die Stützstruktur 8 ist zweckmäßig aus einem Bahnenmaterial 20 hergestellt, das bei den Ausführungsformen der Fig. 1-3 beispielsweise wellenförmig gefaltet bzw. gewellt sein kann. Grundsätzlich sind jedoch hier quasi beliebige gefaltete bzw. gewellte Konfigurationen denkbar. Beispielsweise zeigt Fig. 4 ein rechteckförmig gefaltetes Bahnenmaterial 20, während Fig. 6 ein zick-zack-förmig gefaltetes Bahnenmaterial 20 zeigt. Fig. 7 zeigt eine komplexe Wellenform, bei der sich innerhalb des Bahnenmaterials 20 omega-förmige Abschnitte 21 und sinusförmige Abschnitte 22 regelmäßig abwechseln oder in beliebiger Reihenfolge aufeinanderfolgen. Eine derartige gemischte Formgebung kann von besonderem Vorteil sein, da auf diese Weise einerseits mit den sinus-förmigen Abschnitten 22 die Stützstruktur 8 durch die Kompression versteift wird, während sie andererseits mit den omega-förmigen Abschnitten 21 die Komprimierung elastischer aufnehmen kann. Durch eine gezielte Auswahl und Abfolge der sinus-förmigen und omega-förmigen Abschnitte 21, 22 kann eine gewünschte Versteifungs- und Abstützungswirkung in der Stützstruktur 8 realisiert werden.

Die einzelnen Wellen oder Falten des Bahnenmaterials 20 erstrecken sich dabei mit ihrer Erstreckungsrichtung bzw. Längsrichtung parallel zur Längsrichtung des Rohrkörpers 2. Besagte Längsrichtung steht in den Querschnitten senkrecht auf der Zeichnungsebene.

Fig. 5 zeigt eine andere Ausführungsform der Stützstruktur 8, bei der sie zumindest ein Rohr 23 aufweist bzw. durch ein Rohr 23 gebildet ist. Zweckmäßig verläuft auch hier eine Längsrichtung des Rohrs 23 parallel zur Längsrichtung des Rohrkörpers 2.

Die Stützstruktur 8 kann eine strukturierte Oberfläche besitzen, derart, dass sich der Strömungswiderstand erhöht und die Wärmeübertragung verbessert ist. Insbesondere kann mit Hilfe einer gezielten Oberflächenstrukturierung die Entstehung turbulenter Grenzschichten unterstützt werden. Die Stützstruktur 8 besitzt dann die Zusatzfunktion eines Turbulators.

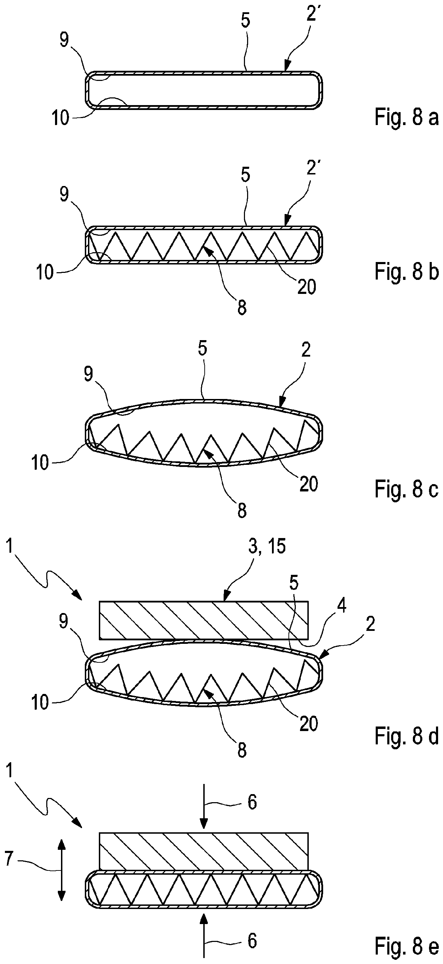

Im Folgenden wird mit Bezug auf die Fig. 8a-8e ein bevorzugtes Verfahren zum Herstellen der Wärmeübertragungsanordnung 1 bzw. des Wärmeübertragers 12 näher erläutert:
Zunächst wird gemäß Fig. 8a ein Rohling für den Rohrkörper 2 bereitgestellt, der in Fig. 8a mit 2' bezeichnet ist. In diesen Rohling 2' wird gemäß Fig. 8b die Stützstruktur 8 eingebracht. Dabei ist es grundsätzlich möglich, die Stützstruktur 8 am Rohrkörper 2 bzw. am Rohling 2' zu befestigen. Bevorzugt wird dabei die Stützstruktur 8 nur an einer der beiden Innenseiten 9, 10 befestigt, beispielsweise mittels eines Lötvorgangs. Beispielsweise wird die Stützstruktur 8 nur auf der Innenseite 10 befestigt. Alternativ dazu kann die Stützstruktur 8 auch an beiden Innenseiten 9, 10 befestigt sein.

Gemäß Fig. 8c erfolgt dann eine Umformung des Rohrkörpers 2 bzw. des Rohlings 2', derart, bis die Außenseite 5 nach außen konvex gewölbt ist. Jetzt hat der Rohrkörper 2 seine Endform im unverspannten Zustand erreicht. Sofern die Stützstruktur 8 nur an der einen Innenseite 10 befestigt ist, hebt die andere Innenseite 9 bei diesem Umformvorgang von der Stützstruktur 8 ab. Sofern die Stützstruktur 8 an beiden Innenseiten 9, 10 befestigt ist, kommt es beim Umformvorgang auch zu einer plastischen Verformung der Stützstruktur 8.

Die Schnittansichten der Fig. 1 bis 8 zeigen jeweils einen Querschnitt des Rohrkörpers 2 quer zu dessen Längsrichtung. Die in den Fig. 3 und 8c gezeigte konvexe Wölbung ist dabei in diesen Querschnitten realisiert, erfolgt also in der Querrichtung des Rohrkörpers 2. Ebenso kann der Rohrkörper 2 in seiner Längsrichtung gewölbt sein, so dass die konvexe Wölbung dann im Längsschnitt realisiert ist. Somit können zwei sich senkrecht überlagernde Wölbungen vorliegen, was zu einer räumlichen bzw. sphärischen Wölbung führt. Hierdurch ergibt sich ein in der Längsrichtung des Rohrkörpers 2 variierender Querschnitt mit variierenden Wölbungsradien für den Rohrkörper 2.

Gemäß Fig. 8d kann nun der Kontaktkörper 3 am Rohrkörper 2 angeordnet werden. Dies entspricht dann dem unverspannten Zustand der Anordnung 1 gemäß Fig. 3.

Anschließend erfolgt die Verspannung der Anordnung 1 mit der Vorspannkraft 6 in der Vorspannrichtung 7, was zu dem in Fig. 8e wiedergegebenen verspannten Zustand der Anordnung 1 führt, was auch dem Zustand der Fig. 1 entspricht.

Die Umformung des Rohrkörpers 2 bzw. des Rohlings 2' kann dabei beispielsweise mittels eines Innenhochdruckumformverfahrens realisiert werden.

Zum Herstellen des Wärmeübertragers 12 werden die Rohrkörper 2 bzw. die Rohre 13, 14 und die Kontaktkörper 3 bzw. die thermoelektrischen Generatoren 15 aufeinander gestapelt und anschließend im Stapel, mit oder ohne Gehäuse 16, verspannt.

## Patentansprüche

1. Anordnung zur Wärmeübertragung zwischen einem zum Führen eines Fluids geeigneten Rohrkörper (2) und einem damit in Kontakt stehenden Kontaktkörper (3),
- wobei der Kontaktkörper (3) eine dem Rohrkörper (2) zugewandte Kontaktseite (4) aufweist, mit welcher der Kontaktkörper (3) mit einer dem Kontaktkörper (3) zugewandten Außenseite (5) des Rohrkörpers (2) in Kontakt steht,
- wobei in einem verspannten Zustand der Anordnung (1) eine Vorspannkraft (6) den Kontaktkörper (3) in einer Vorspannrichtung (7) gegen den Rohrkörper (2) andrückt,
- wobei die Außenseite (5) in einem unverspannten Zustand der Anordnung (1) zum Kontaktkörper (3) konvex gewölbt ist,
- wobei die Außenseite (5) im verspannten Zustand gegenüber dem unverspannten Zustand deformiert ist und flächig an der Kontaktseite (4) anliegt,
- wobei im Inneren des Rohrkörpers (2) eine Stützstruktur (8) angeordnet ist, die sich im verspannten Zustand an zwei einander gegenüberliegenden Innenseiten (9, 10) des Rohrkörpers (2) in der Vorspannrichtung (7) abstützt,
- wobei die Stützstruktur (8) nur an einer der beiden Innenseiten (9, 10) befestigt ist.

2. Anordnung nach Anspruch 1,
**dadurch gekennzeichnet,**
**dass** die Stützstruktur (8) an der jeweiligen Innenseite (9, 19) mittels eines Lötvorgangs befestigt ist.

3. Anordnung nach Anspruch 1 oder 2,
**dadurch gekennzeichnet,**
**dass** die Kontaktseite (4) im unverspannten Zustand im Querschnitt des Kontaktkörpers (3) eben ist.

4. Anordnung nach einem der Ansprüche 1 bis 3,
**dadurch gekennzeichnet,**
**dass** die Kontaktseite (4) und die Außenseite (5) im verspannten Zustand im Querschnitt der Körper (2, 3) in einer Ebene (11) flächig aneinander liegen.

5. Anordnung nach einem der Ansprüche 1 bis 4,
**dadurch gekennzeichnet,**
**dass** die Stützstruktur (8) aus einem, insbesondere wellenförmig oder zick-zack-förmig oder rechteckförmig, gefalteten oder gewellten Bahnenmaterial (20) gebildet ist, wobei insbesondere vorgesehen sein kann, dass sich eine Erstreckungsrichtung oder Längsrichtung der Wellen oder Falten parallel zur Längsrichtung des Rohrkörpers (2) erstreckt.

6. Anordnung nach einem der Ansprüche 1 bis 3,
**dadurch gekennzeichnet,**
**dass** die Stützstruktur (8) zumindest ein Rohr (23) aufweist oder durch dieses gebildet ist, wobei insbesondere vorgesehen sein kann, dass eine Längsrichtung des Rohrs (23) parallel zur Längsrichtung des Rohrkörpers (2) verläuft.

7. Anordnung nach einem der Ansprüche 1 bis 6,
**dadurch gekennzeichnet,**
**dass** der Kontaktkörper (3) ein thermoelektrischer Generator (15) ist.

8. Anordnung nach einem der Ansprüche 1 bis 7,
**dadurch gekennzeichnet,**
- **dass** zwischen der Kontaktseite (4) und der Außenseite (5) eine Wärmeleitschicht (19) angeordnet ist, oder
- **dass** die Kontaktseite (4) und/oder die Außenseite (5) eine Wärmeleitschicht (19) aufweist/aufweisen.

9. Wärmeübertrager für eine Abgasanlage einer Brennkraftmaschine, insbesondere eines Kraftfahrzeugs,
- mit mindestens einem Warmrohr (13) zum Führen eines wärmeabgebenden Fluids,
- mit mindestens einem Kaltrohr (14) zum Führen eines wärmeaufnehmenden Fluids,
- mit mindestens einem thermoelektrischen Generator (15) zum Wandeln einer Temperaturdifferenz in elektrische Spannung,
- wobei der jeweilige thermoelektrische Generator (15) jeweils zwischen einem Kaltrohr (14) und einem Warmrohr (13) angeordnet ist und mit diesem verspannt ist,
- wobei der jeweilige thermoelektrische Generator (15) mit zumindest einem solchen Rohr (13, 14) als Anordnung (1) nach einem der Ansprüche 1 bis 8 ausgestaltet ist,
- wobei der Rohrkörper (2) der Anordnung (1) durch das jeweilige Rohr (13, 14) gebildet ist und der Kontaktkörper (3) der Anordnung (1) durch den jeweiligen thermoelektrischen Generator (15) gebildet ist.

10. Wärmeübertrager nach Anspruch 9,
**dadurch gekennzeichnet,**
**dass** der Wärmeübertrager (12) ein Gehäuse (16) aufweist, das zwei Gehäusehälften (17, 18) besitzt, die in der Vorspannrichtung (7) ineinandergesteckt sind, wobei die Vorspannkraft (6) in die Gehäusehälften (17, 18) und über diese auf die Anordnungen (1) aufgebracht wird.

11. Verfahren zum Herstellen einer Anordnung (1) nach einem der Ansprüche 1 bis 8,
- bei dem die Stützstruktur (8) in den jeweiligen Rohrkörper (2) eingebracht wird,
- bei dem anschließend der jeweilige Rohrkörper (2) umgeformt wird, bis seine Außenseite (5) nach außen konvex gewölbt ist,
- bei dem anschließend der jeweilige Kontaktkörper (3) am Rohrkörper (2) angeordnet wird,
- bei dem anschließend die Anordnung (1) aus wenigstens einem Rohrkörper (2) und wenigstens einem Kontaktkörper (3) verspannt wird.

12. Verfahren nach Anspruch 11,
**dadurch gekennzeichnet,**
**dass** die Umformung des jeweiligen Rohrkörpers (2) mittels Innenhochdruckumformung erfolgt.

## Claims

1. An arrangement for the heat transfer between a tubular body (2) suitable for conducting a fluid and a contact body (3) that is in contact with said tubular body,
- wherein the contact body (3) comprises a contact side (4) facing the tubular body (2), with which the contact body (3) with an outside (5) facing the contact body (3) is in contact with the tubular body (2),
- wherein in a tensioned state of the arrangement (1) a preload force (6) presses the contact body (3) against the tubular body (2) in a preload direction (7),
- wherein the outside (5) in an un-tensioned state of the arrangement (1) is convexly curved towards the contact body (3),
- wherein the outside (5) in the tensioned state is deformed relative to the un-tensioned state and bears surface-to-surface against the contact side (4),
- wherein in the interior of the tubular body (2) a support structure (8) is arranged, which in the tensioned state supports itself on two inner sides (9, 10) of the tubular body (2) located opposite each other in the preload direction (7),
- wherein the support structure (8) is only fastened to one of the two inner sides (9, 10).

2. The arrangement according to Claim 1, **characterized in that** the support structure (8) is fastened to the respective inner side (9, 10) by means of a soldering process.

3. The arrangement according to Claim 1 or 2, **characterized in that** the contact side (4) in the un-tensioned state is flat in the cross section of the contact body (3).

4. The arrangement according to any one of Claims 1 to 3, **characterized in that** the contact side (4) and the outside (5) in the tensioned state in the cross section of the body (2, 3) bear against each other surface-to-surface in one plane (11).

5. The arrangement according to any one of the Claims 1 to 4, **characterized in that** the support structure (8) is formed of a more preferably wave-shaped or zigzag-shaped or rectangularly folded or corrugated web material (20), wherein it can be more preferably provided that an extension direction or longitudinal direction of the waves or pleats extends parallel to the longitudinal direction of the tubular body (2).

6. The arrangement according to any one of the Claims 1 to 3, **characterized in that** the support structure (8) comprises at least one tube (23) or is formed by such, wherein it can be more preferably provided that a longitudinal direction of the tube (23) runs parallel to the longitudinal direction of the tubular body (2).

7. The arrangement according to any one of the Claims 1 to 6, **characterized in that** the contact body (3) is a thermoelectric generator (15).

8. The arrangement according to any one of the Claims 1 to 7, **characterized in**
- **that** between the contact side (4) and the outside (5) a heat conductive layer (19) is arranged, or
- **that** the contact side (4) and/or the outside (5) comprises/comprise a heat conductive layer (19).

9. A heat transfer device for an exhaust system of a combustion engine, more preferably of a motor vehicle,
- with at least one warm tube (13) for conducting a heat-emitting fluid,
- with at least one cold tube (14) for conducting a heat-absorbing fluid,
- with at least one thermoelectric generator (15) for converting a temperature differential into electric voltage,
- wherein the respective thermoelectric generator (15) in each case is arranged between a cold tube (14) and a warm tube (13) and tensioned together with these,
- wherein the respective thermoelectric generator (15) is configured with at least one such tube (13, 14) as arrangement (1) according to any one of the Claims 1 to 8,
- wherein the tubular body (2) of the arrangement (1) is formed through the respective tube (13, 14) and the contact body (3) of the arrangement (1) is formed by the respective thermoelectric generator (15).

10. The heat transfer device according to claim 9, **characterized in that** the heat transfer device (12) comprises a housing (16) having two housing halves (17, 18) which are inserted into each other in the preload direction (7), wherein the preload force (6) is applied to the housing halves (17, 18) and via these to the arrangements (1).

11. A method for producing an arrangement (1) according to any one of the Claims 1 to 8,
- wherein the support structure (8) is introduced in the respective tubular body (2),
- wherein the respective tubular body (2) is subsequently formed until its outside (5) is convexly curved to the outside,
- wherein subsequently the respective contact body (3) is arranged on the tubular body (2),
- wherein subsequently the arrangement (1) of at least one tubular body (2) and at least one contact body (3) is tensioned together.

12. The method according to Claim 11, **characterized in that** the forming of the respective tubular body (2) is effected by means of internal high-pressure forming.

## Revendications

1. Agencement de transfert de chaleur entre un corps tubulaire (2) approprié pour guider un fluide et un corps de contact (3) en contact avec celui-ci,
- dans lequel le corps de contact (3) présente un côté de contact (4) faisant face au corps tubulaire (2), avec lequel le corps de contact (3) est en contact avec un côté extérieur (5) du corps tubulaire (2) faisant face au corps de contact (3),
- dans lequel, dans un état serré de l'agencement (1), une force de sollicitation (6) presse le corps de contact (3) dans une direction de sollicitation (7) contre le corps tubulaire (2),
- dans lequel le côté extérieur (5), dans un état desserré de l'agencement (1), est bombé de manière convexe par rapport au corps de contact (3),
- dans lequel le côté extérieur (5) est déformé dans l'état serré par rapport à l'état desserré, et repose à plat sur le côté de contact (4),
- dans lequel une structure de support (8) est agencée à l'intérieur du corps tubulaire (2), qui, dans l'état serré, s'appuie sur deux côtés intérieurs opposés l'un à l'autre (9, 10) du corps tubulaire (2) dans la direction de sollicitation (7),
- dans lequel la structure de support (8) étant fixée uniquement à l'un des deux côtés intérieurs (9, 10).

2. Agencement selon la revendication 1,
**caractérisé en ce que**
la structure de support (8) est fixée au côté intérieur respectif (9,19) au moyen d'un soudage.

3. Agencement selon la revendication 1 ou 2,
**caractérisé en ce que**
le côté de contact (4) est plan dans l'état desserré en section transversale du corps de contact (3).

4. Agencement selon l'une quelconque des revendications 1 à 3,
**caractérisé en ce que**
le côté de contact (4) et le côté extérieur (5), dans l'état serré en section transversale des corps (2, 3), reposent à plat l'un contre l'autre dans un plan (11).

5. Agencement selon l'une quelconque des revendications 1 à 4,
**caractérisé en ce que**
la structure de support (8) est formée à partir d'un matériau en feuille (20) plié ou ondulé, en particulier de forme ondulée ou en zigzag ou de forme rectangulaire, dans lequel il peut en particulier être prévu qu'une direction d'extension ou une direction longitudinale des ondulations ou plis s'étend parallèlement à la direction longitudinale du corps tubulaire (2).

6. Agencement selon l'une quelconque des revendications 1 à 3,
**caractérisé en ce que**
la structure de support (8) présente au moins un tube (23) ou est formée par celui-ci, dans lequel il peut en particulier être prévu qu'une direction longitudinale du tube (23) s'étend parallèlement à la direction longitudinale du corps tubulaire (2).

7. Agencement selon l'une quelconque des revendications 1 à 6,
**caractérisé en ce que**
le corps de contact (3) est un générateur thermoélectrique (15).

8. Agencement selon l'une quelconque des revendications 1 à 7,
**caractérisé en ce que**
- entre le côté de contact (4) et le côté extérieur (5) est agencée une couche conductrice de chaleur (19), ou
- le côté de contact (4) et/ou le côté extérieur (5) présente/présentent une couche conductrice de chaleur (19).

9. Échangeur de chaleur pour un système d'échappement d'un moteur à combustion interne, en particulier d'un véhicule automobile,
- avec au moins un tube chaud (13) pour guider un fluide dégageant de la chaleur,
- avec au moins un tube froid (14) pour guider un fluide dégageant de la chaleur,
- avec au moins un générateur thermoélectrique (15) pour transformer une différence de température en tension électrique,
- dans lequel le générateur thermoélectrique respectif (15) est agencé entre un tube froid (14) et un tube chaud (13) et est serré avec celui-ci,
- dans lequel le générateur thermoélectrique respectif (15) est conçu avec au moins un tel tube (13, 14) en tant qu'agencement (1) selon l'une quelconque des revendications 1 à 8,
- dans lequel le corps tubulaire (2) de l'agencement (1) est formé par le tube respectif (13, 14) et le corps de contact (3) de l'agencement (1) est formé par le générateur thermoélectrique respectif (15).

10. Échangeur de chaleur selon la revendication 9,
**caractérisé en ce que**
l'échangeur de chaleur (12) présente un boîtier (16) qui possède deux moitiés de boîtier (17, 18) qui sont emboîtées l'une dans l'autre dans la direction de sollicitation (7), dans lequel la force de sollicitation (6) est appliquée dans les moitiés de boîtier (17, 18) et par leur intermédiaire aux agencements (1).

11. Procédé de fabrication d'un agencement (1) selon l'une quelconque des revendications 1 à 8,
- dans lequel la structure de support (8) est introduite dans le corps tubulaire respectif (2),
- dans lequel le corps tubulaire respectif (2) est ensuite transformé jusqu'à ce que son côté extérieur (5) soit bombé de manière convexe vers l'extérieur,
- dans lequel le corps de contact respectif (3) est ensuite agencé sur le corps tubulaire (2),
- dans lequel l'agencement (1) d'au moins un corps tubulaire (2) et d'au moins un corps de contact (3) est ensuite serré.

12. Procédé selon la revendication 11,
**caractérisé en ce que**
la transformation du corps tubulaire respectif (2) s'effectue au moyen d'une transformation à haute pression interne.
